# EUROPEAN PATENT SPECIFICATION

(11) **EP 4 229 664 B1**
(45) Date of publication and mention of the grant of the patent: **23.10.2024**
(21) Application number: 21786380.2
(22) Date of filing: 29.09.2021
(51) Int. Cl.: H01G 11/28, H01G 11/36, H01G 11/70, H01G 11/86, H01G 11/46, H01G 11/48

(54) **DIRECT GROWTH CROSS-LINKED CARBON NANOTUBES ON MICROSTRUCTURED METAL SUBSTRATE FOR SUPERCAPACITOR APPLICATION**
DIREKTWACHSTUMSVERNETZTE KOHLENSTOFFNANORÖHRCHEN AUF MIKROSTRUKTURIERTEM METALLSUBSTRAT ZUR SUPERKONDENSATORANWENDUNG
NANOTUBES DE CARBONE RÉTICULÉS À CROISSANCE DIRECTE SUR UN SUBSTRAT MÉTALLIQUE MICROSTRUCTURÉ POUR APPLICATION DE SUPERCONDENSATEUR

(30) Priority: 15.10.2020 NO 20201116
(43) Date of publication of application: 23.08.2023
(73) Proprietor: University of South-Eastern Norway, 3603 Kongsberg (NO)
(72) Inventor: DU, Kang, 3184 Borre (NO); CHEN, Xuyuan, 1365 Blommenholm (NO); ØHLCKERS, Per Alfred, 1394 Nesbru (NO)
(74) Representative: Bryn Aarflot AS
(86) International application number: PCT/EP2021/076796
(87) International publication number: WO 2022/078759

(56) References cited:
- EP-A1- 1 061 043
- WO-A1-2022/216727
- WO-A2-2005/065425
- US-A1- 2010 178 531
- NASSOY FABIEN ET AL: "Single-Step Synthesis of Vertically Aligned Carbon Nanotube Forest on Aluminium Foils", NANOMATERIALS, vol. 9, no. 11, 9 November 2019 (2019-11-09), pages 1590, XP055870192, DOI: 10.3390/nano9111590
- KUMAR SACHIN ET AL: "0D to 3D carbon-based networks combined with pseudocapacitive electrode material for high energy density supercapacitor: A review", CHEMICAL ENGENEERING JOURNAL, ELSEVIER, AMSTERDAM, NL, vol. 403, 22 July 2020 (2020-07-22), XP086299375, ISSN: 1385-8947, [retrieved on 20200722], DOI: 10.1016/J.CEJ.2020.126352

## Description

### Field of the invention

The present invention generally relates to the field of electrical energy storage devices. More particularly, the present invention relates to the electrode by direct growth cross-linked carbon nanotubes on a microstructured metal substrate and supercapacitors made of these electrodes.

### Background of the invention

Supercapacitors, also known as an electrochemical capacitor (EC) or electronic double-layer capacitor (EDLC), is a unique electrical energy storage devices. Compared to the batteries, supercapacitors have the advantages in higher power density, faster charging-discharging, longer life span, and broader operating temperature.

Usually, supercapacitors have the potential used in the field of mid-range energy storage due to a lower energy density than batteries. Supercapacitors are physically storing the charges on the surface of the electrode and achieving the separation of charge in a Helmholtz double layer at the interface between the electrode surface and an electrolyte. One example of such a supercapacitor based on a silicon substrate is shown in WO2018/162580. Therefore, the corresponding capacitance and energy density of supercapacitors are proportional to the surface area of electrode materials. In order to increase the energy density of supercapacitors, two requirements are put forward on the active material: (1) a superb electrical conductivity, which a prerequisite condition to make sure the chargers can flow quickly during charging/discharging, and (2) a larger effective surface area, which is an essential condition to offer enough positions for chargers adherence.

Carbon nanotubes (CNTs), deriving from the development of nanoscience and nanotechnology, possess unique properties, such as extraordinary mechanical, excellent electrical conductivity, and nanoscale sizes making them suitable for a promising application in the field of energy storage. A typical method for a CNTs layer synthesized by chemical vapor deposition (CVD) is using Fe nanoparticles as the catalysts which are deposited on a barrier layer of Al₂O₃ or SiO₂ (Reference: Kenji Hata et al. Science 306, 1362 (2004); O. Pitkänen, et al. Scientific Reports 7.1 (2017): 1-7.). Other examples using nanotube on metal foil are discussed in US7553341, Fabien Nassoy et al: "Single step synthesis of a vertically aligned carbon nanotube forest on aluminum foils"; Nanomaterials 2019, 9, 1590, and Itir Bakis Dogru et al.; "Flexible supercapacitor electrodes with vertically aligned nanotubes grown on aluminum foils." Progress in Natural Science: Materials International 26 (2016) 232-236. However, there are several drawbacks associated with such a CNTs layer for supercapacitor applications. First, the existence of a barrier increases the contact resistance between the CNTs layer and the current collector. Second, this CNTs layer perpendicular to the substrate, which is a loose structure with a small mass density that is not beneficial to improve the energy density of supercapacitors.

Other example of the prior art are discussed in WO2008/048347 where aligned nanostructures are provided on a surface, where the surface has been patterned to provide catalyst island where the nanotubes as grown. In WO2005/065425 presents a method for initiating nanostructure growth where a catalyst is deposited on a resistive element prior to a heating process. CN108217628 describes a method for making a threedimensional network of nanotubes from an alumina template, such as a through hole, containing nickel sulfate particles, where the nanotubes are upright relative to the surface and includes further nanotubes linking the upright nanotubes.

In addition, several methods use CNTs ink or CNTs nanocomposites to form an electrode on a current collector (Reference: Bolin Chen et al., "Fully packaged carbon nanotube supercapacitors by direct ink writing on flexible substrates." ACS applied materials & interfaces 9, no. 34 (2017): 28433-28440, and Wei Gong et al., "Carbon nanotubes and manganese oxide hybrid nanostructures as high performance fiber supercapacitors." Communications Chemistry 1, no. 1 (2018): 1-8.). Supercapacitor assembled with such electrodes shows poor equivalent series resistance (ESR) because a binder is often used to hold the CNTs layer on the current collector, resulting in increased contact resistance and further limiting the power density of supercapacitors. Besides, charge transfer across parallel CNTs generally is more resistive than that via inner tube paths in interconnected CNTs. WO2005/065425

Pai Lu et al. reported a method to synthesize a carbon nanotube film on etched silicon for on-chip supercapacitor (Pub. No.: US 2020/001356A1, and Pai Lu et al., "Taper silicon nano-scaffold regulated compact integration of 1D nanocarbons for improved on-chip supercapacitor." Nano Energy 41 (2017): 618-625.). Silicon is a good candidate substrate to develop on-chip supercapacitor due to compatible with intergrated circuits chip manufacturing. However, the silicon substrate is not flexible, and more expensive and poor conductivity comparing to metal film substrates.

Additional prior art disclosing synthesis or growth of nanostructures comprising nanotubes on a substrate are be found in US 2010178531 and in EP1061043.

It is therefore and object of the present invention to provide a method for fabricating a high-performance supercapacitor electrode without the above-described problems.

A further object of the present invention is to offer an electrode that can be mass-produced and used for energy storage devices.

The objects of the invention are solved by providing a method, electrode and supercapacitor as defined in the accompanying claims.

According to the invention a method is provided for directly growing cross-linked carbon nanotubes on a metal| current collector film without using a binder or a barrier layer, and also a method for synthesizing highly dense cross-linked carbon nanotubes with an interconnected structure and high mass loading.

More in detail the present invention thus provides a process for fabricating an electrode by use of a direct growth cross-linked carbon nanotubes on a microstructured metal substrate, which can also act as a current collector. More specifically, the process begins to form the microstructures on the surface of a metal film substrate. Next, the microstructured substrate is coated with a metal layer or metal compounds which can convert into metal nanoparticles by subsequent heat treatment in a reducing gas atmosphere. Finally, the cross-linked carbon nanotubes are grown on the microstructured substrate under the catalysis of metal nanoparticles by atmospheric pressure chemical vapor deposition (APCVD) technique. A supercapacitor assembled with such electrodes exhibits an extremely high capacitance and an excellent equivalent series resistance (ESR).

### Summary of the invention

The present invention provides a process for fabricating an electrode as well as the resulting electrode and supercapacitor utilizing said electrode, which composes a microstructured metal film substrate (current collector), metal nanoparticles, and cross-linked carbon nanotubes directly grown onto the current collector. The process comprises: (a) forming the microstructures on a metal film substrate for achieving surface gain and enabling cross-linked CNTs growth; (b) depositing metal or metal compounds layer on the surface of the microstructures; (c) converting metal or metal compounds layer into metal nanoparticles as the catalysts; (d) growing cross-linked carbon nanotubes on the microstructures in the presence of the catalysts. Specifically, the surface area of the microstructured metal film substrate is enlarged, offering larger space than the flat metal film substrate to deposit plenty of metal nanoparticles as catalysts for growing CNTs. Simultaneously, the irregular surface provides a scaffold template to grow CNTs along various directions to achieve CNTs interweaving together, eventually forming highly dense cross-linked carbon nanotubes with high mass loading coated onto the microstructured metal film substrate. More particularly, the highly-dense cross-linked carbon nanotubes are directly grown on the current collector without a binder or a barrier layer, which effectively reduces the contact resistance between the cross-linked carbon nanotubes and the current collector. Supercapacitors assembled with such electrodes could show a high capacitance and a low equivalent series resistance (ESR). Also, cross-linked carbon nanotubes are a superb scaffold structure for loading with pseudocapacitive materials to form a pseudocapacitive electrode. Typically, pseudocapacitive materials include transition metal oxides (manganese oxide, nickel oxide, cobalt oxide, and ruthenium oxide) and conductive polymers (polyaniline, polypyrrole, and Poly(3,4-ethylene dioxythiophene): poly(4-styrene sulfonate) (PEDOT: PSS)).

The metal film substrate involved in this invention could be any metals, which can be fabricated with a microstructured surface with corresponding fabricating methods. The microstructured surface can support metal nanoparticles as the catalysts and simultaneously offer a scaffold template to direct grow cross-linked carbon nanotubes on the metal film substrate. The metal film substrate includes any type of metals, such as aluminum, copper, nickel, titanium, chromium, or stainless steel. The metal film substrates should have impurity controlled for leakage current optimization. The metal film substrate should form a stable electrochemical system with the electrolyte. Both dry and wet etching can be applied to create the microstructures on these metal film substrates by physical or chemical ways, such as chemical etching, mechanical lapping, or laser etching, etc. The structures are with uniaxial open down to the substrate about sub-microns to tens microns deep and range from submicron to microns wider at the top, preferably within the range of 0.5 to 50 microns deep depending on the thickness of the metal film substrate and 0.4 to 5 microns wide.

According to the invention, aluminum (Al) is the preferred metal but not limited to Al based on its properties.
(1) Al has superior conductivity compared with silver, copper, and gold, facilitating the ESR reduction of supercapacitors.
(2) Al is a light metal with a relatively low density to improve the energy density (Wh/Kg) and power density (W/Kg) of supercapacitors.
(3) Al is ductile, and its ductility allows the supercapacitor structure can be packaged into cylindrical, stacking, or flat jellyroll cells.
(4) Al is easy to fabricate with irregular structures on the surface by chemical (acid etching) or physical method (mechanical lapping, laser etching etc.).
(5) Al has good chemical stability in organic electrolytes used in supercapacitors.
(6) Al is the most abundant metal on Earth. It is beneficial to develop inexpensive supercapacitors.

The metal film substrate in this invention is therefore preferable using aluminum foil as an example to grow directly cross-linked carbon nanotubes. Therefore, aluminum foil is involved in some embodiments as one of the metal substrates.

In some embodiments, the metal film substrate includes any structural type of metal products, such as: flat metal foil, porous metal foil.

According to the present invention, there is provided the methods to deposit metal or metal compounds layer on the microstructured metal film substrate by physical vapor deposition (PVD) or coating with metal compound precursors.

In some embodiments, a metal layer deposited by physical vapor deposition (PVD) may include electron-beam evaporation, thermal evaporation, or sputtering.

In some embodiments, metal compounds layer deposited by precursors may include dip coating or spray coating.

In some embodiments, the element of the metal layer includes nickel, iron, cobalt, or a mixture of any of the above; metal compounds have nickel compound, iron compound, cobalt compound, or a combination of any of the above.

In some embodiments, a metal compound precursor is prepared by dissolving the metal compounds into a soluble solvent (typically: water or organic solvents).

According to the present invention, there is provided the methods to form metal nanoparticles on the microstructured metal film substrate by heat treatment in a reducing atmosphere (typically: hydrogen) using a per se known process. The method preferably comprises the following steps: (a) oxidized metal layer is reduced to the metal layer, and further formed to metal nanoparticles; or (b) the formation of metal nanoparticles from the metal compounds is achieved by the simultaneous action of pyrolysis and reduction reactions. During heat treatment, surface energy plays a crucial role in the nucleation process. The size and number of metal nanoparticles are depended on the thickness of the metal layer or the concentration of the metal compound, heating rate, and holding temperature.

In some embodiments, the size of nickel nanoparticles is around 5-100 nm, and the nickel clusters have a larger size of 0.5-2 µm during heat treatment at 100-400 °C in a hydrogen atmosphere.

According to the present invention, there is provided a method to grow cross-linked carbon nanotubes on the microstructured metal film substrate. This method is a typical catalytic process for producing carbon material through the APCVD technique, which is well-known to the skilled person. Carbon-containing gas is decomposed into carbon atoms, which are further orderly assembled to form CNTs (more specifically, multi-walled carbon nanotubes (MWCNTs)) in the presence of the metal catalysts at the temperature of 400~600 °C. Ultimately, abundant CNTs are intertwined together to form highly dense cross-linked carbon nanotubes.

In some embodiments, the carbon-containing gas includes acetylene, methane, ethylene, propane, butane, or a mixture of any of the above.

In some embodiments, the thickness of the cross-linked carbon nanotubes can reach up to 1200 µm (mass loading: up to~60 mg/cm²).

In an embodiment of the present invention provides electrodes to assemble supercapacitor for electrical energy storage, wherein the supercapacitor structure comprises: at least two opposing electrodes, the separator between any two electrodes, and electrolyte permeated into the electrodes and the separators. The supercapacitor structure can further be packaged into a cylindrical, stacking, flat jellyroll cell, or surface mounting device.

In a variation on this embodiment, the electrode used in electrical energy storage devices include: capacitor, battery, or hybrid capacitor.

### Brief description of the figures

FIG. 1 illustrates a single-side electrode made of deposited cross-linked carbon nanotubes on the microstructured metal film substrate;
FIG. 2 depicts a double-side electrode made of deposited cross-linked carbon nanotubes on the microstructured metal film substrate;
FIG. 3A to FIG. 3D illustrates the process of fabricating a single-side electrode used in a supercapacitor according to the present invention;
FIG. 4A to FIG. 4D depicts the process of fabricating a the double-side electrode used in a supercapacitor according to the present invention;
FIG. 5 illustrates a typically basic supercapacitor structure based on single-side electrodes in accordance with an embodiment of the present invention;
FIG. 6 depicts a typical multi-layer supercapacitor structure based on single-side electrodes and double-side electrodes in accordance with an embodiment of the present invention;
FIG. 7A presents the surface morphologies of the microstructured aluminum foil (as the metal substrate example) fabricated by chemical acid etching, with the scanning electron microscopy characterization technique;
FIG. 7B presents the surface morphologies of the microstructured aluminum foil (as the metal substrate example) fabricated by electrochemical acid etching, with the scanning electron microscopy characterization technique;
FIG. 8A illustrates the surface morphologies of nickel catalysts formed on chemical acid etched aluminum foil (as the metal substrate example) by solution precursor spray technique;
FIG. 8B depicts the surface morphologies of nickel catalysts formed on electrochemical acid etched aluminum foil (as the metal substrate example) by solution precursor spray technique;
FIG. 8C presents the surface morphologies of nickel catalysts deposited on chemical acid etched aluminum foil (as the metal substrate example) by electron beam evaporation technique;
FIG. 8D illustrates the surface morphologies of nickel catalysts deposited on electrochemical acid etched aluminum foil (as the metal substrate example) by electron-beam evaporation technique;
FIG. 9A depicts the surface morphologies of cross-linked carbon nanotubes on etched aluminum foil by atmospheric pressure chemical vapor deposition (APCVD) technique;
FIG. 9B illustrates the cross-section of the cross-linked carbon nanotubes on etched aluminum foil by atmospheric pressure chemical vapor deposition (APCVD) approach;
FIG. 10A presents the cyclic voltammetry (CV) properties for the assembled supercapacitor at various scan rates from 200 mV/s to 10 mV/s in the voltage of 0-2.7 V according to the present invention;
FIG. 10B illustrates the calculated capacitance normalized to the area and mass loading of cross-linked carbon nanotubes for the assembled supercapacitor according to the present invention;
FIG. 11 depicts the Nyquist plot of the assembled supercapacitor obtained by electrochemical impedance spectroscopy (EIS) measurement from 100 kHz to 100 mHz;
FIG. 12 illustrates the capacitance retention for the assembled supercapacitor in accordance with an embodiment of the present invention.

### A detailed description of the invention

### Supercapacitor electrode

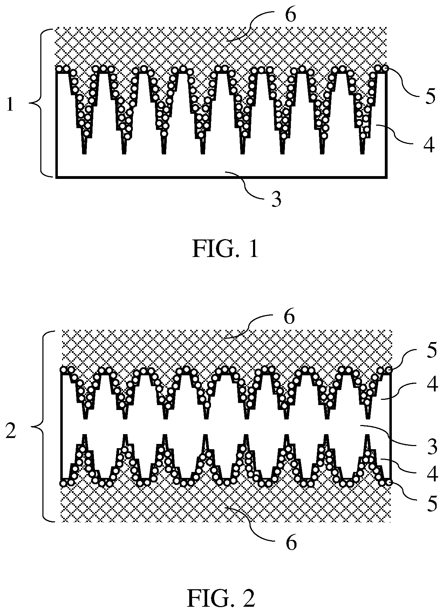

FIG. 1 illustrates a single-side electrode for supercapacitors in accordance with the present invention. Single-side electrode **1** comprises metal microstructures **4** formed on one side of the metal film substrate **3,** or "current collector" **3,** the deposited metal nanoparticles **5,** and cross-linked carbon nanotubes **6.** FIG. 2 depicts a double-side electrode for supercapacitors in accordance with the present invention. Double-side electrode **2** composes metal microstructures **4** formed on both sides of the metal film substrate **3,** or "current collector" **3,** the deposited metal nanoparticles **5,** and cross-linked carbon nanotubes **6.**

For any person skilled in the art, the illustrations of FIG. 1 and FIG. 2 are schematics only, in which layer thickness, aspect ratios, shapes, etc. are not necessarily correct.

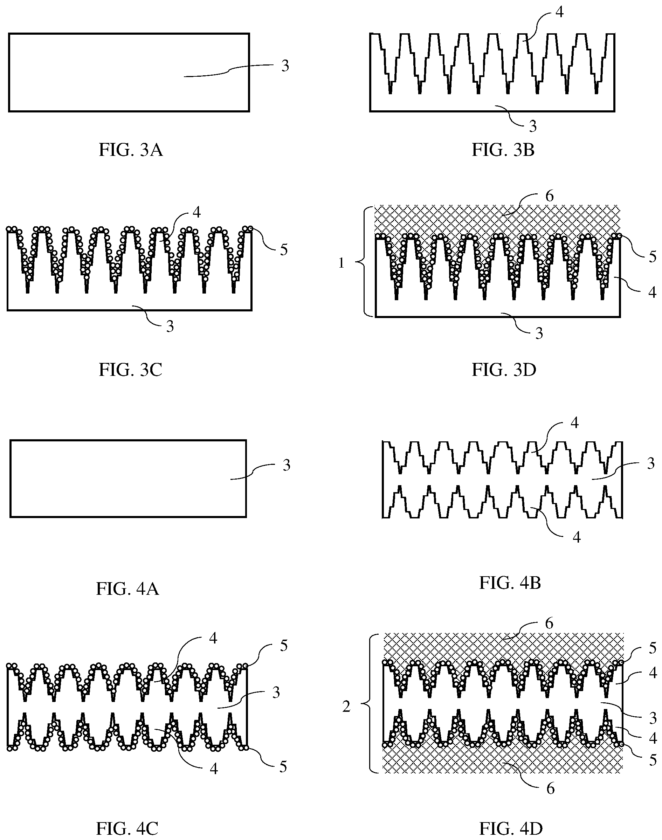

FIG. 3A to FIG. 3D principally illustrates the process of fabricating metal microstructures **4,** deposited with metal nanoparticles **5,** and cross-linked carbon nanotubes **6** on the single-side electrode **1,** according to an embodiment of the present invention. FIG. 4A to FIG. 4D depicts the process of fabricating metal microstructures **4,** deposited with metal nanoparticles **5,** and cross-linked carbon nanotubes **6** on the double-side electrode **2,** according to an embodiment of the present invention.

Single-side electrode **1** and double-side electrode **2** have the same fabrication processes. Single-side electrode **1** is only fabricated with metal microstructures **4,** deposited with metal nanoparticles **5,** and coated with cross-linked carbon nanotubes **6** on one side of the metal film substrate **3.** Double-side electrode **2** is fabricated with metal microstructures **4,** deposited with metal nanoparticles **5,** and coated with cross-linked carbon nanotubes **6** on both sides of the metal film substrate **3.**

### Preparation of supercapacitor electrode

The preparation supercapacitor electrode in this invention involves four steps: (1) forming metal microstructures **4** on the metal film substrate **3;** (2) depositing metal or metal compounds layer on the surface of metal microstructures **4;** (3) converting metal or metal compounds layer into metal nanoparticles **5** as the catalysts; (4) growing cross-linked carbon nanotubes **6** on the metal microstructures **5** in the presence of the catalysts. Aluminum foil, one of the typical metal film substrate, is used as the current collector in supercapacitor. Therefore, aluminum foil is used as one example of a metal film substrate to show the detailed fabrication process.

### Fabrication of microstructured aluminum foil

Before etching, aluminum foil is sequentially cleaned by deionized water, acetone, and isopropanol. Then, aluminum foil is performed surface alkali treatment by NaOH solution (1 mol/L) at 50-60 °C for 2-3 minutes. For a typical chemical acid etching, aluminum foil is etched by a mixed acid solution of 1 mol/L HCl and 3 mol/L H₂SO₄ at the temperature of 40~50 °C for the etching time of 3-6 hours. The etching time is one of the parameters to control the shape size and aspect ratio of aluminum microstructures on aluminum foil. The following reactions are carried out in chemical acid etching.

2A1 + 6HC1 → 2AlCl₃ + 3H₂

2A1 + 3H₂SO₄ → Al₂(SO₄)₃ + 3H₂

For a typical electrochemical acid etching, aluminum foil is performed in an electrochemical cell as the working electrode, and platinum foil is used as the counter electrode. Aluminum foil is etched under a constant current density of 100-400 mA/cm² in a mixed solution of 1 mol/L HCl and 3 mol/L H₂SO₄ at the temperature of 70-80 °C for the etching time of 30~600 seconds. Similarly, the shape size and aspect ratio of aluminum microstructures are controlled by constant current density and etching time. For etching single-side aluminum microstructures, one side of aluminum foil is protected by tape and the other side is exposed to the mixed solution. For etching double-side aluminum microstructures, both sides of aluminum foil are without protection, which can contact and reaction with the mixed solution. The following equations take place during electrochemical acid etching.

Anode (aluminum foil): Al → Al³⁺ + *3e⁻*

Cathode (platinum foil): 2H⁺ + *2e⁻* → H₂

As stated above this results in a microstructured surface having surface features with uniaxial open down to the substrate in the range of sub-microns to tens of microns deep and from submicron to microns wider at the top, preferably within the range of 0.5 To 50 microns deep depending on the thickness of the metal film substrate and 0.4 to 5 microns wide.

### Deposition of nickel nanoparticles on microstructured aluminum foil

After etching aluminum foil, aluminum microstructures are deposited and coated with nickel nanoparticles, as shown in FIG. 3C and FIG. 4C. Typically, there are two methods to load with nickel nanoparticles **5** on aluminum microstructures **4,** nickel electron beam evaporation, and nickel compound pyrolysis. Nickel electron beam evaporation is a physical vapor deposition. Specifically, the aluminum foil etched with aluminum microstructures is fixed in a vacuum chamber with a pressure of 5×10⁻⁷ to 1×10⁻⁶ Torr. The nickel atoms are simulated from nickel source by a constant current of 70~90 mA for the deposition time of 40 to 200 minutes. The electron beam deposition is performed under a pressure of 1×10⁻⁶ to 5×10⁻⁶ Torr with the argon flow of 10 sccm at the room temperature of 20~25 °C. The deposited nickel on the microstructured aluminum foil will expose in the air atmosphere after taking from the vacuum chamber, resulting in the formation of nickel oxide on the aluminum microstructures.

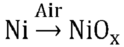

For the nickel compound pyrolysis method, various nickel precursors can be prepared by dissolving nickel compounds (NiCl₂, Ni(NO₃)₂, or Ni(CH₃CO₂)₂, etc.) in water, methanol, or ethanol. Then, these nickel precursors are sprayed on the microstructured aluminum foil. For the single-side electrode, nickel precursors only spray on one side of the microstructured aluminum foil, and both sides are sprayed for the double-sided electrode. Nickel compounds are well coated on the surface of aluminum microstructures as the solvent evaporation, and the following equations have described the formation of nickel compounds.

NiCl₂ solution → NiCl₂ · 6H₂O

Ni(NO₃)₂ solution → Ni(NO₃)₂ · 6H₂O

Ni(CH₃CO₂)₂ solution → Ni(CH₃CO₂)₂ · xH₂O, where x can be 0, 2, and 4.

### Growth of cross-linked carbon nanotubes on microstructured aluminum foil

Cross-linked carbon nanotubes are the primary activated material for electric double-layer capacitors (EDLC). FIG. 3D and FIG. 4D depict cross-linked carbon nanotubes **6** formed on aluminum microstructures **4** under the catalysis of nickel nanoparticles **5** by atmospheric pressure chemical vapor deposition (APCVD) technique. The forming mechanism of the APCVD process is known to the skilled person.

In a typical process, the microstructured aluminum foil deposited with nickel or nickel compounds is placed in the center of the tube furnace. The air in the tube furnace is bumped out and then filled with an Argon gas several times to reduce oxygen content. Then, 300~500 sccm of Ar and 50-150 sccm of H₂ is introduced into the tube to maintain atmospheric pressure. The tube furnace is heated up to 400~600°C at the heating rate of 10°C. When the temperature reached to 400~600°C, 5-20 sccm C₂H₂ carbon-containing gas is introduced into the tube and held at the temperature of 400~600°C for 10 minutes to 2 hours. After that, C₂H₂, H₂, and Ar supply are shut off, and the tube furnace is cooled down to room temperature (25°C) in a nitrogen atmosphere with a flow rate of 400 sccm. At the end of the APCVD process, the cross-linked carbon nanotubes are produced on the microstructured aluminum foil. In an APCVD process, the following reactions are taking place, forming cross-linked carbon nanotubes on microstructured aluminum foil.

### Ni nanoparticle formation

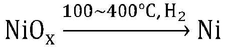

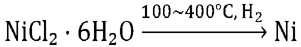

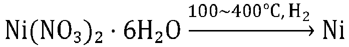

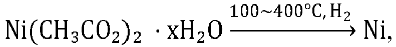

where x can be 0, 2, and 4.

### Carbon materials formation

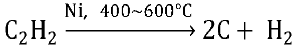

### Supercapacitor

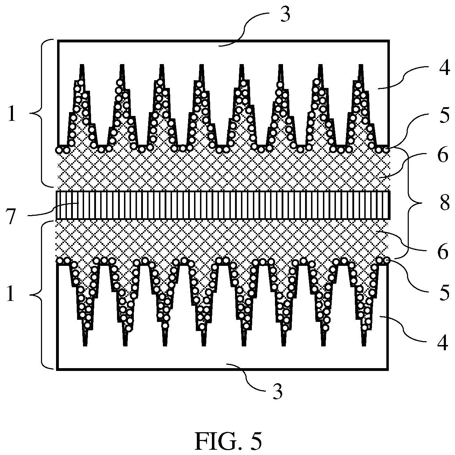

FIG. 5 illustrates a typically basic supercapacitor structure based on single-side electrodes in accordance with an embodiment of the present invention. Supercapacitor comprises two single-side electrode **1.** Each single-sided electrode **1** further composes metal microstructures **4** fabricated on one side of a metal film substrate **3,** or "current collector" **3,** the deposited nickel nanoparticles **5,** and cross-linked carbon nanotubes **6.** Two single-side electrode **1** are typically separated by a solid separator **7,** which provides a physical barrier between two electrodes to prevent short circuits. Separator **7** is an ion-permeable membrane with high porosity to allow the flow of electrolyte **8** for charging and discharging. Typical separators used in supercapacitors are cellulose and glass fiber due to their chemical stability. Electrolyte **8** can fill into the gaps of cross-linked carbon nanotubes **6,** the gaps between metal microstructures **4** , and the pores of separator **7.** Note that electrolyte **8** can be neutral (Na₂SO₄), organic electrolytes, or ionic electrolytes. Any single-side electrode **1** can be selected as the positive or negative terminal of a supercapacitor.

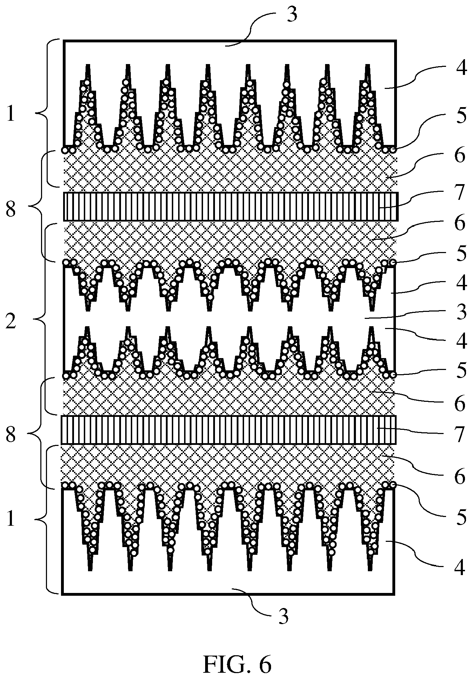

FIG. 6 depicts a typically multi-layer supercapacitor structure based on single-side electrodes and double-side electrodes in accordance with an embodiment of the present invention. Supercapacitor comprises two single-side electrode **1** and one double-side electrode **2.** Single-side electrode **1** and double-side electrode **2** has the same fabricating steps: forming metal microstructures **4,** depositing with nickel nanoparticles **5,** and growing with cross-linked carbon nanotubes **6.** The electrode layers are physically isolated by a separator **7.** Electrolyte **8** can permeate into the gaps of cross-linked carbon nanotubes **6,** the gaps between metal microstructures **4,** and the pores of separator **7.** The multi-layer supercapacitor structure has the same working principle as the basic supercapacitor structure. The separator **7** and electrolyte **8** used in basic supercapacitor structure are also usable to multi-layer supercapacitor structure. For any person skilled in the art, multi-layer supercapacitor structure can further be packaged into cylindrical, stacking, or flat jelly roll cells.

### Characterization of electrode materials

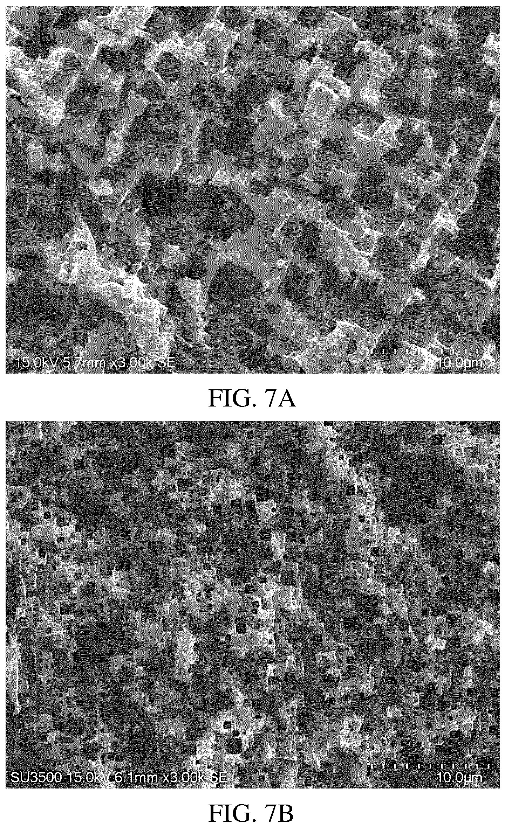

FIG. 7A presents the surface morphologies of the microstructured aluminum foil obtained by the chemical etching method in a mixed acid solution of 1 mol/L HCl and 3 mol/L H₂SO₄ at the temperature of 40~50 °C for the etching time of 5 hours. In a typical chemical acid etching, the surface of aluminum foil is rough of irregular pits and plateaus, which are consistently distributed throughout the entire surface. In some embodiments, typical sizes of plateaus are 1×2 µm, and a specific depth of the pit is 15-40 µm.

FIG. 7B presents the surface morphologies of the microstructured aluminum foil fabricated by electrochemical acid etching method applying a constant current density of 200 mA/cm² in a mixed solution of 1 mol/L HCl and 3 mol/L H₂SO₄ at the temperature of 75 °C for the etching time of 300 seconds. After performed electrochemical acid etching, aluminum foil is fully etched with pits, plateaus, and tunnels. The size of pits and plateaus are smaller than that etched by chemical acid etching, shown in FIG. 7A. In some embodiments, the tunnels are presented as a rectangle shape with a size of 0.5-2 µm. The typical depth of tunnels can reach up to ~50 µm.

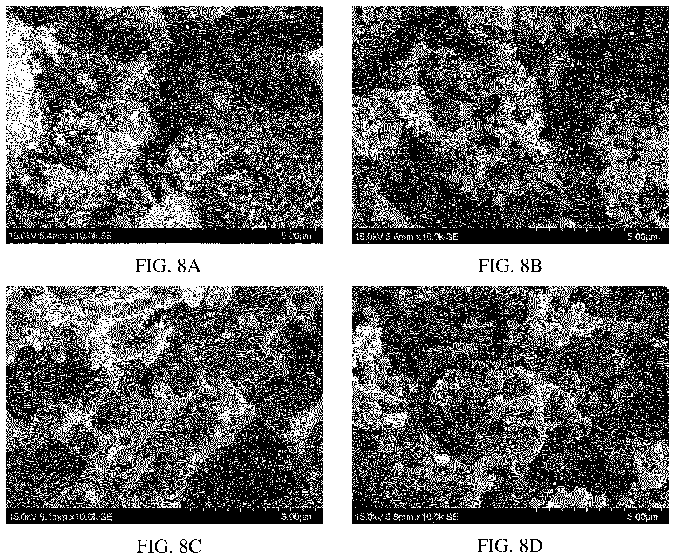

FIG. 8A and FIG. 8B illustrate the surface morphologies of nickel catalysts formed on etched aluminum foil by solution precursor spray technique. Nickel nanoparticles or clusters are formed on microstructured aluminum foil after heat treatment at 100-400 °C in a hydrogen atmosphere. In some embodiments, the size of nickel nanoparticles is around 5-100 nm, and the nickel clusters have a larger size of 0.5-2 µm. Note that nickel nanoparticles or clusters can fully form on the surface of microstructured aluminum foil because nickel solution precursors can permeate into all gaps among aluminum microstructures.

FIG. 8C and FIG. 8D present the surface morphologies of nickel nanoparticles deposited on etched aluminum foil by electron-beam evaporation technique. Nickel nanoparticles are uniformly deposited on the exposed surface of microstructured aluminum foil. Note that nickel nanoparticles can not deposit on the unexposed surfaces due to the shadowing effect.

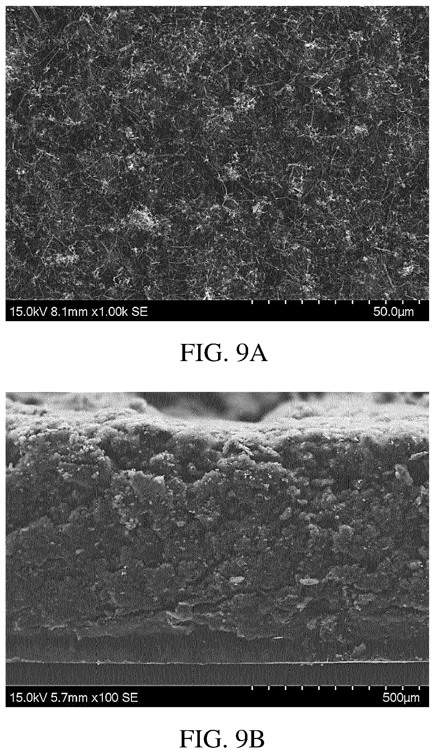

FIG. 9A depicts the surface morphologies of the cross-linked carbon nanotubes on microstructured aluminum foil by atmospheric pressure chemical vapor deposition (APCVD) technique. In one embodiment of the present invention, the cross-linked carbon nanotubes are the carbon nanotubes (CNTs), more specifically, single-walled carbon nanotubes (SWCNTs), multi-walled carbon nanotubes (MWCNTs), or a mixture of above.

FIG. 9B illustrates the cross-section of the cross-linked carbon nanotubes on etched aluminum foil by atmospheric pressure chemical vapor deposition (APCVD) technique. The cross-linked carbon nanotubes are directly grown on the microstructured aluminum foil (current collector) to form an interconnecting structure, which is attached well on the current collector.

In one embodiment of the present invention, the thickness of the cross-linked carbon nanotubes can reach up to ~ 1200 µm (mass loading: up to ~60 mg/cm²), and which is adjusted by the number of nickel nanoparticles and the APCVD time. Supercapacitor with such electrodes has the outstanding impedance properties, (1) a reduced contact resistance because of CNT layer is directly grown on the current collector, it does not need a binder to fix carbon layer; (2) a reduced charge transfer resistance due to the superb the electrical conductivity of CNT and interweaved structure in the carbon layer.

### Electrochemical capacitive performances

A supercapacitor is assembled to investigate the capacitive performances of the cross-linked carbon nanotubes electrode. Two electrodes (each in the size of 1×1cm, mass loading of 32 mg) are packaged into a stainless steel button cell (CR2032) by a digital pressure controlled electric crimper (MSK-160E). Tetraethylammonium tetrafluoroborate (Et₄NBF₄, 1 mol/L in acetonitrile) is used as the electrolyte, and the glass fiber filter is used as the separator. The cyclic voltammetry (CV) and electrochemical impedance spectroscopy (EIS) are performed by an electrochemical potentiostat (BioLogic VSP-300). The Kelvin connection clips are used during the tests to eliminate the effect of contact resistance.

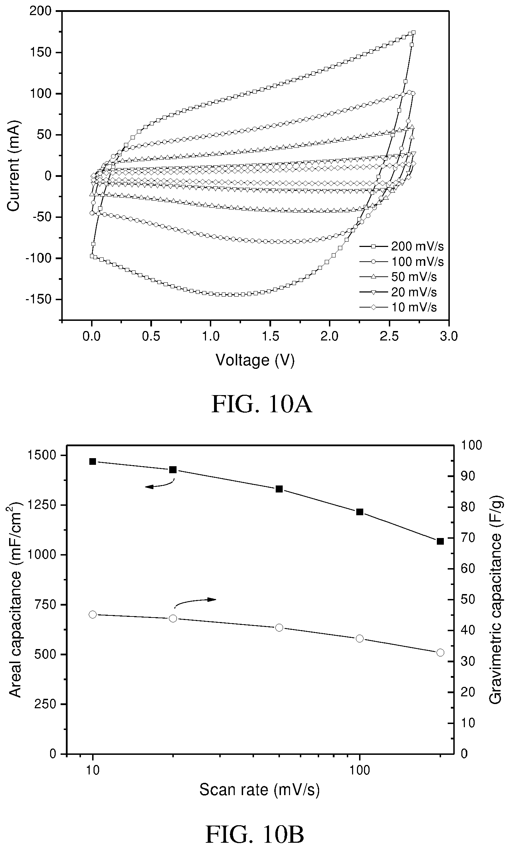

FIG. 10A presents the cyclic voltammetry properties for the assembled supercapacitor at various scan rates from 200 mV/s to 10 mV/s in the voltage of 0-2.7 V according to the present invention. It is well known that the enclosed area of the CV curve presents the performance of the capacitor.

FIG. 10B illustrates the calculated capacitance normalized to the area and mass loading of cross-linked carbon nanotubes for the assembled supercapacitor according to the present invention. The areal and gravimetric capacitance is 1469 mF/cm² and 45.9 F/g at the scan rate of 10 mV/s, respectively.

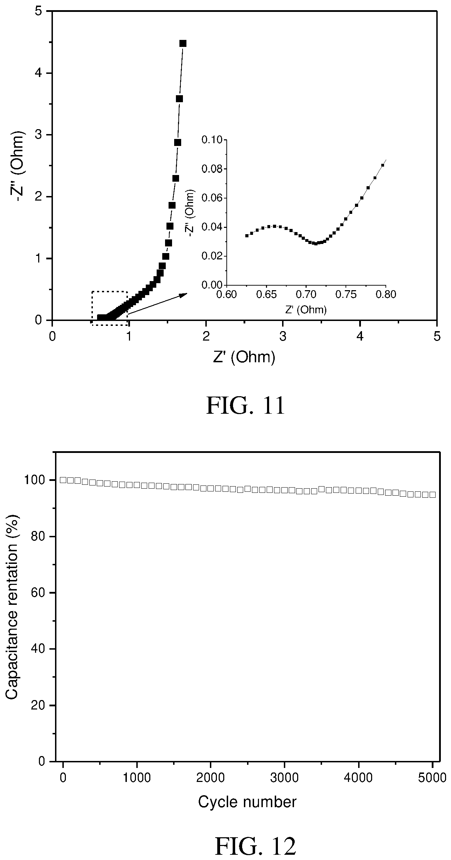

FIG. 11 depicts the Nyquist plot of the assembled supercapacitor obtained by electrochemical impedance spectroscopy (EIS) measurement from 100 kHz to 100 mHz. It is shown that R_{con} (contact resistance), R_{cht} (charge transfer resistance), and R_{idf} (ion diffusion resistance) of the assembled supercapacitor are 0.63 Q, 0.08 Q, and 0.66 Q, respectively.

FIG. 12 illustrates the capacitance retention for the assembled supercapacitor in accordance with an embodiment of the present invention. The supercapacitor shows outstanding cycling stability of 95% capacitance retention after 5000 charge/discharge cycles.

### Examples

Various electrodes are prepared by the APCVD technique. The prepared electrodes are loaded with different carbon mass from 12.7 mg to 52.2 mg, which are controlled by the number of nickel nanoparticles and the APCVD time (20~60 minutes).

Several supercapacitors are packaged into stainless steel button cell (CR2032), shown as example1~example7. Tetraethylammonium tetrafluoroborate (Et₄NBF₄, 1mol/L in acetonitrile) and the glass fiber filter are used as the electrolyte and the separator, respectively. The corresponding CV and EIS of examples are tested by an electrochemical potentiostat (BioLogic VSP-300). The calculated capacitance normalized to the area of cross-linked carbon nanotubes are listed in TABLE 1. The areal capacitance of examples is increased from 550 mF/cm² to 2009 mF/cm² as the function of carbon mass loadings from 12.7 mg to 52.2 mg. The corresponding gravimetric capacitances are also calculated from 32.7 to 43.3 F/g.

**TABLE 1**

| | Mass loading (mg) | Areal capacitance (mF/cm²) | Gravimetric capacitance (F/g) | R_{con} (Ω) | R_{cht} (Ω) | R_{idf} (Ω) |
|---|---|---|---|---|---|---|
| Example1 | 12.7 | 550 | 43.3 | 0.54 | 0.09 | 0.63 |
| Example2 | 23.5 | 1031 | 43.9 | 0.85 | 0.15 | 0.64 |
| Example5 | 30.5 | 1181 | 38.7 | 0.62 | 0.09 | 0.65 |
| Example4 | 32.6 | 1217 | 37.3 | 0.77 | 0.13 | 0.59 |
| Example5 | 38.7 | 1266 | 32.7 | 0.65 | 0.12 | 0.66 |
| Example6 | 42.2 | 1425 | 33.8 | 0.66 | 0.16 | 0.58 |
| Example7 | 52.2 | 2009 | 38.5 | 0.75 | 0.37 | 0.82 |

To summarize the present invention relates to a method for fabricating an electrode for a supercapacitor based on carbon nanotubes. The electrode composes a microstructured metal film substrate (current collector) and cross-linked carbon nanotubes grown onto the current collector. The method comprising the process of:
- Etching the surface of a metal substrate with microstructures constituting a surface roughness having depth variations preferably in the range from of submicron to tens of microns, especially 0.5 to 50 microns and preferably from submicron to microns wider at the top, especially within the range of 0.4 to 5 microns;
- depositing metal layer or metal compounds on the surface of metal microstructures using a deposit technique or a solution;
- converting metal layer or metal compounds into metal nanoparticles, e.g. through heat treatment, providing the catalysts;
- growing cross-linked carbon nanotubes on the metal microstructures in the presence of the catalysts.

This way an electrode may be fabricated with the method described above constituted by said metal microstructures, metal catalysts, and cross-linked carbon nanotubes, which can be formed on the single or double side of the metal film substrate.

The electrode may be used to assemble a supercapacitor structure comprising two single-side electrodes, separator, and electrolyte. The supercapacitor may also include a double-sided electrode, the supercapacitor structure comprising two single-side electrodes, one double-side electrode, separator, and electrolyte. The supercapacitor structure can further be packaged into cylindrical, stacking, flat jellyroll cells. or surface mounting device as the metal film substrate is flexible.

The metal film substrate includes any structural type of metal products, such as: flat metal foil; or porous metal foil suitable for being provided with the microstructures within the suitable size range adapted to receiving and maintaining the catalyst particles interacting with the carbon nanotubes.

The metal film substrate may be constituted by or include any type of material capable of receiving and containing the metal layer or compound, preferably one or more of aluminum, copper, nickel, titanium, chromium, or stainless steel. The microstructures in the metal film substrate can be fabricated by a physical or chemical method.

The deposion of the metal layer on the substrate can be achieved by electron-beam evaporation, thermal evaporation, or sputtering and may include nickel, iron, cobalt, or a mixture of any of the above.

The deposition of a metal compound layer can be achieved by dip coating or spray coating using a metal compound precursor and may include a nickel compound, iron compound, cobalt compound, or a mixture of any of the above. The metal compound precursors can be prepared by dissolving the metal compounds into a soluble solvent, such as: water, methanol, ethanol, acetone, diethyl ether, or ethyl acetate, etc.

The process of converting the metal or metal compounds layer into metal nanoparticles is performed at 100-400 °C in a hydrogen atmosphere, where the formed metal nanoparticles include nickel nanoparticles, iron nanoparticles, cobalt nanoparticles, or a mixture of any of the above.

The growing of cross-linked carbon nanotubes may be formed by the catalytic pyrolysis of carbon-containing gas by APCVD at 400~600 °C, where the carbon-containing gases include acetylene, methane, ethylene, propane, butane, or a mixture of any of the above.

The cross-linked carbon nanotubes may include at least one of the following: single-walled carbon nanotubes (SWCNTs); and multi-walled carbon nanotubes (MWCNTs).

The cross-linked carbon nanotubes can be acted as a scaffold structure for loading with pseudocapacitive materials to form a pseudocapacitive electrode. The pseudocapacitive electrode may include transition metal oxides such as at least one of manganese oxide, nickel oxide, cobalt oxide, and ruthenium oxide, and conductive polymers include at least one of polyaniline, polypyrrole, and Poly(3,4-ethylene dioxythiophene): poly(4-styrene sulfonate) (PEDOT: PSS). The pseudocapacitor may comprise: at least two opposing pseudocapacitive electrodes, the separator between any two pseudocapacitive electrodes, and electrolyte permeated into the pseudocapacitive electrodes and the separators.

The supercapacitor according to the invention for electrical energy storage, preferably comprises: at least two opposing electrodes, the separator between any two electrodes, and electrolyte permeated into the electrodes and the separators. It may also include pseudocapacitive materials include transition metal oxides or conductive polymers.

## Claims

1. Method for fabricating an electrode (1;2) for a supercapacitor, the method includes the following process steps:
• in a surface of a metal film substrate (3), etching microstructures (4) with a predetermined roughness,
• depositing in said microstructures (4) a metal or metal compound layer,
• converting said metal or compounds layer into metal nanoparticles (5), constituting a catalyst,
• growing cross linked carbon nanotubes (6) in said microstructures (4) at said metal nanoparticle (5) acting as catalysts.

2. Method according to claim 1, wherein the metal film substrate includes any type of metals, such as: aluminum, copper, nickel, titanium, chromium, or stainless steel, preferably aluminum.

3. Method according to claim 1, wherein depositing with the metal layer is be achieved by electron-beam evaporation, thermal evaporation, or sputtering.

4. Method according to claim 3, wherein the metal layer includes nickel, iron, cobalt, or a mixture of any of the above.

5. Method according to claim 1, wherein said depositing of the metal compound layer can be achieved by dip coating or spray coating using a metal compound precursor.

6. Method according to claim 5, wherein the metal compounds include nickel compound, iron compound, cobalt compound, or a mixture of any of the above.

7. Method according to 5, wherein the metal compound precursors can be prepared by dissolving the metal compounds into a soluble solvent, such as: water, methanol, ethanol, acetone, diethyl ether, or ethyl acetate, etc.

8. Method according to claim 1, wherein converting metal or metal compounds layer into metal nanoparticles is performed at 100-400 °C in a hydrogen atmosphere.

9. Method according to claim 8, wherein the formed metal nanoparticles include nickel nanoparticles, iron nanoparticles, cobalt nanoparticles, or a mixture of any of the above.

10. Method according to claim 1, wherein growing cross-linked carbon nanotubes is formed by the catalytic pyrolysis of carbon-containing gas by APCVD at 400~600 °C.

11. Method according to claim 10, wherein the carbon-containing gases include acetylene, methane, ethylene, propane, butane, or a mixture of any of the above.

12. Method according to claim 1, wherein the metal film substrate includes any structural type of metal products, such as: flat metal foil; or porous metal foil.

13. Method according to claim 1, wherein the metal film substrate with microstructures is be fabricated by a physical or chemical method.

14. Method according to claim 1, wherein the cross-linked carbon nanotubes include at least one of the following: single-walled carbon nanotubes (SWCNTs); and multi-walled carbon nanotubes (MWCNTs).

15. Method according to claim 1, wherein the cross-linked carbon nanotubes can be acted as a scaffold structure for loading with pseudocapacitive materials to form a pseudocapacitive electrode.

16. Method according to claim 15, wherein pseudocapacitive materials include transition metal oxides or conductive polymers.

17. Method according to claim 15, wherein transition metal oxides include at least one of manganese oxide, nickel oxide, cobalt oxide, and ruthenium oxide.

18. Method according to claim 15, wherein conductive polymers include at least one of polyaniline, polypyrrole, and Poly(3,4-ethylene dioxythiophene): poly(4-styrene sulfonate) (PEDOT: PSS).

19. Electrode (1;2) for a supercapacitive component, the electrode being fabricated according to the method of any of the preceding claims, being constituted by a metal film substrate (3) having a microstructure (4) on at least one surface, said microstructure including cross-linked carbon nanotubes (6).

20. Electrode according to claim 19, wherein the microstructure includes features with uniaxial open down to the substrate about sub-microns to tens microns deep and range from submicron to microns wide at the top, preferably within the range of 0.5 to 50 microns deep depending on the thickness of the metal film substrate and 0.4 to 5 microns wide.

21. Supercapacitor including at least opposing electrodes (1;2), wherein at least one electrode being constituted by an electrode (1;2) according to claim 19 or 20.

22. Supercapacitor according to claim 21, including two electrodes (1;2) each having said microstructure (4) including cross-linked carbon nanotubes (6) on each side facing each other, a separator (7) and an electrolyte (8) in the space separating them.

23. Supercapacitor according to claim 21, comprising two single-sided electrodes having said microstructure and nanotubes facing each other and being separated by one double sided electrode, the single and double sided electrodes being separated by separators and electrolyte.

24. Use of a supercapacitor according to claim 21 for electrical energy storage, comprising at least two opposing electrodes, the separator between any two electrodes, and electrolyte permeated into the electrodes and the separators.

## Patentansprüche

1. Verfahren zum Herstellen einer Elektrode (1;2) für einen Superkondensator, wobei das Verfahren die folgenden Prozessschritte einschließt:
• in eine Oberfläche eines Metallfilmsubstrats (3), Ätzen von Mikrostrukturen (4) mit einer zuvor bestimmten Rauheit,
• Abscheiden einer Metall- oder Metallverbindungsschicht in den Mikrostrukturen (4),
• Umwandeln der Metall- oder Verbindungsschicht in Metallnanopartikel (5), die einen Katalysator bilden,
• Züchten von vernetzten Kohlenstoffnanoröhren (6) in den Mikrostrukturen (4) an den Metallnanopartikeln (5), die als Katalysatoren wirken.

2. Verfahren nach Anspruch 1, wobei das Metallfilmsubstrat eine beliebige Art von Metallen einschließt, wie: Aluminium, Kupfer, Nickel, Titan, Chrom oder Edelstahl, vorzugsweise Aluminium.

3. Verfahren nach Anspruch 1, wobei das Abscheiden mit der Metallschicht durch Elektronenstrahlverdampfung, thermische Verdampfung oder Sputtern erreicht wird.

4. Verfahren nach Anspruch 3, wobei die Metallschicht Nickel, Eisen, Cobalt oder eine Mischung beliebiger der oben genannten einschließt.

5. Verfahren nach Anspruch 1, wobei das Abscheiden der Metallverbindungsschicht durch Tauchbeschichten oder Sprühbeschichten unter Verwendung eines Metallverbindungsvorläufers erreicht werden kann.

6. Verfahren nach Anspruch 5, wobei die Metallverbindungen eine Nickelverbindung, eine Eisenverbindung, eine Cobaltverbindung oder eine Mischung beliebiger der oben genannten einschließen.

7. Verfahren nach 5, wobei die Metallverbindungsvorläufer durch Auflösen der Metallverbindungen in einem löslichen Lösungsmittel wie: Wasser, Methanol, Ethanol, Aceton, Diethylether oder Ethylacetat etc. gewonnen werden können.

8. Verfahren nach Anspruch 1, wobei das Umwandeln der Metall- oder Metallverbindungsschicht in Metallnanopartikel bei 100-400 °C in einer Wasserstoffatmosphäre durchgeführt wird.

9. Verfahren nach Anspruch 8, wobei die ausgebildeten Metallnanopartikel Nickelnanopartikel, Eisennanopartikel, Cobaltnanopartikel oder eine Mischung beliebiger der oben genannten einschließen.

10. Verfahren nach Anspruch 1, wobei das Züchten von vernetzten Kohlenstoffnanoröhren durch die katalytische Pyrolyse von kohlenstoffhaltigem Gas durch APCVD bei 400-600 °C ausgebildet wird.

11. Verfahren nach Anspruch 10, wobei die kohlenstoffhaltigen Gase Acetylen, Methan, Ethylen, Propan, Butan oder eine Mischung beliebiger der oben genannten einschließen.

12. Verfahren nach Anspruch 1, wobei das Metallfilmsubstrat eine beliebige strukturelle Art von Metallprodukten umfasst, wie: flache Metallfolie; oder poröse Metallfolie.

13. Verfahren nach Anspruch 1, wobei das Metallfilmsubstrat mit Mikrostrukturen durch ein physikalisches oder chemisches Verfahren hergestellt wird.

14. Verfahren nach Anspruch 1, wobei die vernetzten Kohlenstoffnanoröhren mindestens eines der folgenden einschließen: einwandige Kohlenstoffnanoröhren (SWCNTs); und mehrwandige Kohlenstoffnanoröhren (MWCNTs).

15. Verfahren nach Anspruch 1, wobei die vernetzten Kohlenstoffnanoröhren als eine Gerüststruktur zum Beladen mit pseudokapazitiven Materialien wirken können, um eine pseudokapazitive Elektrode auszubilden.

16. Verfahren nach Anspruch 15, wobei die pseudokapazitiven Materialien Übergangsmetalloxide oder leitfähige Polymere einschließen.

17. Verfahren nach Anspruch 15, wobei die Übergangsmetalloxide mindestens eines von Manganoxid, Nickeloxid, Cobaltoxid und Rutheniumoxid einschließen.

18. Verfahren nach Anspruch 15, wobei die leitfähigen Polymere mindestens eines von Polyanilin, Polypyrrol und Poly(3,4-ethylendioxythiophen): Poly(4-styrolsulfonat) (PEDOT: PSS) einschließen.

19. Elektrode (1;2) für eine superkapazitive Komponente, wobei die Elektrode nach dem Verfahren nach einem der vorstehenden Ansprüche hergestellt wird, durch ein Metallfilmsubstrat (3) gebildet wird, das eine Mikrostruktur (4) auf mindestens einer Oberfläche aufweist, wobei die Mikrostruktur vernetzte Kohlenstoffnanoröhren (6) einschließt.

20. Elektrode nach Anspruch 19, wobei die Mikrostruktur Merkmale einschließt, die einachsig offen nach unten zu dem Substrat von etwa Submikrometern bis einige zehn Mikrometer tief sind und von Submikrometern bis Mikrometern weit an dem obersten Ende reichen, vorzugsweise innerhalb des Bereichs von 0,5 bis 50 Mikrometer tief, abhängig von der Dicke des Metallfilmsubstrats, und 0,4 bis 5 Mikrometer breit sind.

21. Superkondensator, einschließlich mindestens gegenüberliegender Elektroden (1;2), wobei mindestens eine Elektrode durch eine Elektrode (1;2) nach Anspruch 19 oder 20 gebildet wird.

22. Superkondensator nach Anspruch 21, einschließlich zwei Elektroden (1;2), die jeweils die Mikrostruktur (4) einschließlich vernetzter Kohlenstoffnanoröhren (6) an jeder Seite, die einander zugewandt sind, einen Separator (7) und einen Elektrolyten (8) in dem sie trennenden Raum aufweisen.

23. Superkondensator nach Anspruch 21, umfassend zwei einseitige Elektroden, die die Mikrostruktur und die Nanoröhren, die einander zugewandt sind, aufweisen und durch eine doppelseitige Elektrode getrennt sind, wobei die ein- und doppelseitigen Elektroden durch Separatoren und Elektrolyt getrennt sind.

24. Verwendung eines Superkondensators nach Anspruch 21 für eine Speicherung elektrischer Energie, umfassend mindestens zwei gegenüberliegende Elektroden, den Separator zwischen zwei beliebigen Elektroden und Elektrolyt, der in die Elektroden und die Separatoren eingedrungen ist.

## Revendications

1. Procédé de fabrication d'une électrode (1 ;2) pour un supercondensateur, le procédé comporte les étapes de processus suivantes :
• dans une surface d'un substrat de film métallique (3), la gravure des microstructures (4) avec une rugosité prédéterminée,
• le dépôt dans lesdites microstructures (4) d'une couche métallique ou de composé métallique,
• la conversion de ladite couche métallique ou de composés en nanoparticules métalliques (5), constituant un catalyseur,
• la croissance de nanotubes de carbone réticulés (6) dans lesdites microstructures (4) au niveau desdites nanoparticules métalliques (5) agissant comme catalyseurs.

2. Procédé selon la revendication 1, dans lequel le substrat de film métallique comporte un type de métaux quelconque, tel que : l'aluminium, le cuivre, le nickel, le titane, le chrome ou l'acier inoxydable, de préférence l'aluminium.

3. Procédé selon la revendication 1, dans lequel le dépôt de la couche métallique est réalisé par évaporation par faisceau d'électrons, par évaporation thermique ou par pulvérisation cathodique.

4. Procédé selon la revendication 3, dans lequel la couche métallique comporte du nickel, du fer, du cobalt ou un mélange de l'un quelconque de ces éléments.

5. Procédé selon la revendication 1, dans lequel ledit dépôt de la couche de composé métallique peut être réalisé par revêtement par immersion ou par revêtement par pulvérisation à l'aide d'un précurseur de composé métallique.

6. Procédé selon la revendication 5, dans lequel les composés métalliques comportent un composé de nickel, un composé de fer, un composé de cobalt ou un mélange de l'un quelconque de ces composés.

7. Procédé selon 5, dans lequel les précurseurs de composé métallique peuvent être préparés en dissolvant les composés métalliques dans un solvant soluble, tel que l'eau, le méthanol, l'éthanol, l'acétone, l'éther diéthylique ou l'acétate d'éthyle, etc.

8. Procédé selon la revendication 1, dans lequel la conversion de la couche métallique ou de composés métalliques en nanoparticules métalliques est effectuée à 100 à environ 400 °C dans une atmosphère d'hydrogène.

9. Procédé selon la revendication 8, dans lequel les nanoparticules métalliques formées comportent des nanoparticules de nickel, des nanoparticules de fer, des nanoparticules de cobalt ou un mélange de l'une quelconque de ces nanoparticules.

10. Procédé selon la revendication 1, dans lequel les nanotubes de carbone réticulés en croissance sont formés par la pyrolyse catalytique d'un gaz contenant du carbone par APCVD à 400 à environ 600 °C.

11. Procédé selon la revendication 10, dans lequel les gaz contenant du carbone comportent de l'acétylène, du méthane, de l'éthylène, du propane, du butane ou un mélange d'un quelconque de ces gaz.

12. Procédé selon la revendication 1, dans lequel le substrat de film métallique comporte un type structurel de produits métalliques quelconque, tel que : une feuille métallique plate ; ou une feuille métallique poreuse.

13. Procédé selon la revendication 1, dans lequel le substrat de film métallique à microstructures est fabriqué par un procédé physique ou chimique.

14. Procédé selon la revendication 1, dans lequel les nanotubes de carbone réticulés comportent au moins l'un parmi les éléments suivants : des nanotubes de carbone à paroi simple (SWCNT) ; et des nanotubes de carbone à parois multiples (MWCNT).

15. Procédé selon la revendication 1, dans lequel les nanotubes de carbone réticulés peuvent servir de structure d'échafaudage pour être chargés avec des matériaux pseudocapacitifs afin de former une électrode pseudocapacitive.

16. Procédé selon la revendication 15, dans lequel les matériaux pseudocapacitifs comportent des oxydes de métal de transition ou des polymères conducteurs.

17. Procédé selon la revendication 15, dans lequel les oxydes de métal de transition comportent au moins l'un parmi un oxyde de manganèse, un oxyde de nickel, un oxyde de cobalt et un oxyde de ruthénium.

18. Procédé selon la revendication 15, dans lequel les polymères conducteurs comportent au moins l'un parmi polyaniline, polypyrrole et Poly(3,4-éthylène dioxy thiophène): poly(4-styrène sulfonate) (PEDOT: PSS).

19. Électrode (1 ;2) pour un composant supercapacitif, l'électrode étant fabriquée selon le procédé de l'une quelconque des revendications précédentes, étant constituée d'un substrat de film métallique (3) présentant une microstructure (4) sur au moins une surface, ladite microstructure comportant des nanotubes de carbone réticulés (6).

20. Électrode selon la revendication 19, dans laquelle la microstructure comporte des caractéristiques à ouverture uniaxiale vers le bas du substrat d'environ des sous-microns à quelques dizaines de microns de profondeur et d'une plage allant de sous-microns à microns de largeur au sommet, de préférence dans la plage de 0,5 à 50 microns de profondeur en fonction de l'épaisseur du substrat de film métallique et de 0,4 à 5 microns de largeur.

21. Supercondensateur comportant au moins une électrode opposée ; (1 ;2), dans lequel au moins une électrode étant constituée par une électrode (1 ;2) selon la revendication 19 ou 20.

22. Supercondensateur selon la revendication 21, comportant deux électrodes ; (1 ;2), chacune présentant ladite microstructure (4) comportant des nanotubes de carbone réticulés (6) sur chaque face se faisant face, un séparateur (7) et un électrolyte (8) dans l'espace qui les sépare.

23. Supercondensateur selon la revendication 21, comprenant deux électrodes à simple face ayant ladite microstructure et les nanotubes se faisant face et étant séparées par une électrode à double face, les électrodes à simple et double face étant séparées par des séparateurs et l'électrolyte.

24. Utilisation d'un supercondensateur selon la revendication 21 pour le stockage d'énergie électrique, comprenant au moins deux électrodes opposées, le séparateur entre deux électrodes quelconques, et l'électrolyte imprégné dans les électrodes et les séparateurs.
